# EUROPÄISCHE PATENTSCHRIFT

(11) **EP 2 932 523 B1**
(45) Veröffentlichungstag und Bekanntmachung des Hinweises auf die Patenterteilung: **15.02.2017**
(21) Anmeldenummer: 13802538.2
(22) Anmeldetag: 09.12.2013
(51) Int. Cl.: H01J 37/32

(54) **PLASMAQUELLE**
PLASMA SOURCE
SOURCE DE PLASMA

(30) Priorität: 13.12.2012 DE 102012024340
(43) Veröffentlichungstag der Anmeldung: 21.10.2015
(73) Patentinhaber: Oerlikon Surface Solutions AG, Pfäffikon, 8808 Pfäffikon (CH)
(72) Erfinder: KRASSNITZER, Siegfried, A-6800 Feldkirch (AT); HAGMANN, Juerg, CH-9468 Sax (CH)
(74) Vertreter: Troesch Scheidegger Werner AG
(86) Internationale Anmeldenummer: PCT/EP2013/003704
(87) Internationale Veröffentlichungsnummer: WO 2014/090389

(56) Entgegenhaltungen:
- EP-A2- 1 162 647
- US-A- 4 339 691
- US-A1- 2004 018 320
- US-A1- 2007 026 160

## Beschreibung

Die vorliegende Erfindung bezieht sich auf eine Plasmaerzeugungseinrichtung zur Erzeugung eines Plasmas und ein Verfahren zur Erzeugung eines Plasmas in einer Vakuumbeschichtungsanlage zum Beispiel zum Zwecke des Plasmaätzens, Heizens, Nitrierens und Abscheidens von Schichten mittels PE-CVD Prozessen.

Die Erfindung basiert auf einer Plasmaquelle welche nach dem Prinzip der thermischen Elektronenemission und dem Anlegen einer negativen Spannung an einen beheizten Emitter (Schottky Effekt) oder nach dem Prinzip einer Hohlkathodenplasmaquelle funktioniert. Erfindungsgemäss wird für die Plasmaerzeugungseinrichtung als Anode ein elektrisch abgerenzter Hohlraum verwendet, welcher beispielsweise am Vakuumrezipienten ausgestülpt angebracht wird. Dieser Hohlram wird nach Abschalten des Plasmas durch einen shutter-Mechanismus verschlossen wodruch die Kontamination verursacht durch nachfolgende Prozessschritte vermieden wird. Vorzugsweise wird das Einschalten der Plasmaquelle durch Nebenwiderstände gewährleistet.

Eine Plasmaquelle basierend auf dem Prinzip der thermischen Elektronenemission und dem Anlegen einer negativen Spannung an einen beheizten Emitter ist aus der Anmeldung US2004/0018320 A1 bekannt.

Die Erfindung wird nun im Detail und anhand der Figuren beispielhaft erläutert.
- Fig. 1:: Plasmaerzeugungseinrichtung umfassend eine Plasmaquelle, eine Hohlanode sowie Zündhilfen

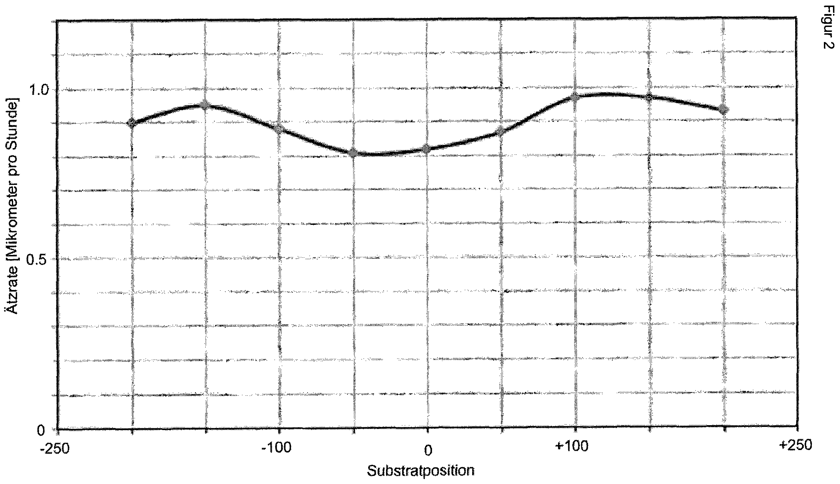

- Fig. 2:: Darstellung der Ätzverteilung: Ätzrate als Funktion der Substratposition
- Fig. 3a-3f:: Varianten der Anordnung von Plasmaquelle und Hohlanode
- Fig. 4:: Anordnung der Plasmaquelle und Hohlanode bei Anlagen mit grösserer Beladungshöhe
- Fig. 5:: Vielzahl von Anodenhohlkörpern mit Schalteinheit

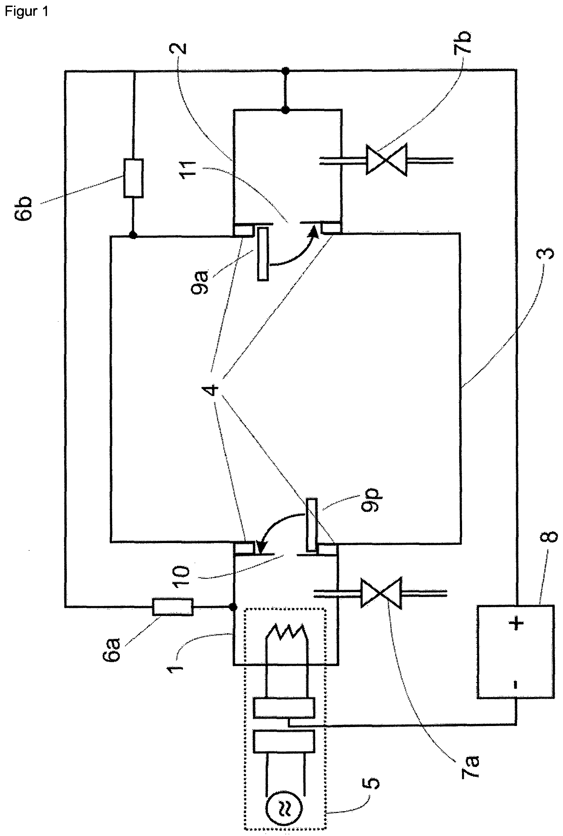

Figur 1 zeigt eine erfindungsgemässe Plasmaerzeugungseinrichtung zur Behandlung von Werkstücken z.B. vor oder während der Beschichtung in einer Vakuumanlage. Gezeigt ist eine Vakuumkammer 3 mit einem über Isolatoren an dieser elektrisch isoliert angeflanschten Plasmaquellenhohlkörper 1 der Teil einer Plasmaquelle ist. Die Plasmaquelle umfasst weiterhin eine Elektronenemissionseinheit 5 welche als Mittel zur Erzeugung von freien Elektronen genutzt wird. Diese Mittel ragen in den Plasmaquellenhohlkörper 1 hinein, so dass die Elektronen im Plasmaquellenhohlkörper 1 erzeugt werden. Beispielsweise wäre ein Wolframfilament, welches auf eine Temperatur von ca. 2700-3000K gebracht wird, als solche Elektronenemissionseinheit 5 geeignet. Durch Anlegen einer negativen Spannung mit Hilfe einer Spannungsquelle 8 an die Elektronenemissionseinheit 5 werden diese zum Elektronenemitter. Durch einen Gaseinlass 7a wird Gas in den Plasmaquellenhohlkörper 1 eingelassen. Das Gas wird durch die von der Elektronenemissionseinheit 5 erzeugten freien Elektronen ionisiert. Als Gas eignet sich z.B. Argon.

Der positive Pol der Spannungsquelle 8 wird über einen Plasmaquellennebenwiderstand (PSsR) mit dem Plasmaquellenhohlkörper 1 elektrisch verbunden. Beim Einschalten der Spannungsquelle kann über diesen Nebenwiderstand 6a Strom fliessen wodurch es möglich wird, Energie in des Plasma im Plasmaquellenhohlkörper 1 einzuspeisen. Das dadurch im Plasmaquellenhohlkörper 1 entstehende Plasma erstreckt sich durch eine im Plasmaquellenhohlkörper 1 vorgesehene Plasmaquellenöffnung 10 in dem Raum der Vakuumkammer 3 und erfüllt diesen.

An die Vakuumkammer 3 über Isolatoren 4 elektrisch isoliert angeflanscht ist zusätzlich ein weiterer Höhlkörper der im folgenden als Anodenhohlkörper 2 bezeichnet wird. Die Vakuumkammer 3 und der Anodenhohlkörper 2 sind durch eine Anodenöffnung 11 miteinander Verbunden. Der Anodenhohlkörper 2 ist elektrisch direkt mit dem positiven Pol der Spannungsquelle 8 verbunden. Im Anodenhohlkörper 2 ist ein Gaseinlass 7b vorgesehen durch den Gas in den Anodenhohlkörper 2 eingelassen wird. Dies kann zum Beispel Argon sein.

Zusätzlich ist die Wand der Vakuumkammer 3 über einen zweiten Nebenwiderstand 6b mit der Spannungsquelle 8 verbunden. Hierdurch wird ermöglicht, dass nun auch ein Entladestrom von der Elektronenemissionseinheit 5 zur Kammerwand fliessen kann. Da der Anodenhohlkörper 2 direkt mit dem positiven Pol der Spannungsquelle 8 verbunden ist kann kommt es vorzugsweise durch den Anodenhohlkörper 2 hindurch zur Entladung und es baut sich im Anodenhohlkörper Plasma auf. Dadurch schliesst sich ein hochstromtauglicher Pfad welcher einen sehr hohen Entladungsstrom bei tiefer Spannung aufnehmen kann. Der Strom kann bis zu einigen 100 Ampere bei einer Spannung von ca. 16V bis 100V betragen.

Die Eigenschaften des so erzeugten Plasmas hängen sehr stark von der Plasmaquellenöffnung 10 und der Anodenöffung 11 ab. Entlang dieser Öffnungen kommt es zur Beschleunigung von Elektronen durch einen Potentialfall und durch die anwesentheit von z.B. Argon Gasatomen zu einer sehr starken Ionisation desselben und zwar vor und innerhalb der Öffnungen. Diese Öffnungen haben vorzugsweise einen Durchmesser zwischen 4mm und 30mm. Bevorzugt betragen die Durchmesser etwa 12mm. Der Abstand zwischen Plasmaquelle und Hohlanode liegt zwischen 200 bis 400mm. Der Abstand der Öffnungen von den zu behandelnden Substraten liegt zwischen 200 und 400mm.

Im vorliegenden Beispiel sind weitere typische Betriebsparameter:
- Gaseinlass Argon:: 50 - 200sccm in die Plasmaquelle und/oder Hohlanode
- Entladestrom:: 200A
- Entladespannung Plasmaquelle:: 16V - 30V
- Entladespannung Hohlanode:: 16 - 100V

Die in der Plasmaquelle und der Hohlanode umgesetzte Leistung muss durch entsprechende, dem Fachmann bekannte Massnahmen weggeführt werden (in Figur 1 nicht dargestellt).

Mittels der oben beschriebenen Plasmaerzeugungsvorrichtung ist es möglich ein stabiles Plasmaverfahren durchzuführen.

Die sonst notwendige Wartung vor jedem Prozessbeginn kann mit der erfindungsgemässen Plasmaerzeugungsvorrichtung entfallen insbesondere wenn die Anode mittels Blenden vor einer Beschichtung geschützt werden kann. Für den Ätzprozess wird die Blende vor der Anodenöffnung geöffnet, so dass sich in der Hohlanode ein Plasma etablieren kann. Für einen eventuell nachfolgenden Beschichtungsprozess, beispielsweise Lichtbogenverdampfen oder Zerstäuben (sputtern) kann die Blende dann mittels eines Shutters geschlossen werden. Entsprechendes gilt für die Öffnung 10 der Plasmaquelle zur Vakuumkammer hin.

Da die Anode selbst aktiv als Plasmaquelle betrieben wird erhöht sich das Plasmavolumen im Vergleich zum Stand der Technik. Die Plasmaerzeugungseinrichtung lässt sich beispielsweise vorteilhaft beim Plasmaätzen, Plasmaheizen und bei der PECVD Beschichtung einsetzen.

Beim Plasmaheizen kann beispielsweise Argon und Wasserstoff eingesetzt werden, wodurch atomarer Wasserstoff erzeugt wird welcher eine hohe Reaktivität aufweisst und sich beispielsweise zur Entfernung von organischen Rückständen eignet.

Im Rahmen der PE-CVD Beschichtung kann beispielsweise Argon als Spülgas für die Plasmaquelle und die Hohlanode verwendet werden. Wird im Rahmen der Beschichtung beispielsweise C₂H₂ und/oder CH₄ oder Gas eines anderen Monomers oder Polymers in die Vakuumkammer gelassen so wird im Plasma un unter Verwendung einer negativen Substratspannung eine Kohlenstoff enthaltende Schicht, beispielsweise eine DLC Schicht (diamond like carbon) abeschieden. Sind die Öffnungen 10, 11 der Plasmaquelle und der Hohlanode entsprechend ausgestaltet so kommt dort es zu einer Überschallströmung. Dies zusammen mit der hohen Energiedichte bewirkt, dass es nicht zu einer Beschichtung der Plasmaquelle und/oder der Hohlanode kommt. Die entsprechenden innenflächen bleiben daher im Wesentlichen unbeschichtet und somit elektrisch leitfähig, was ganz erheblich zur Prozessstabilität beiträgt.

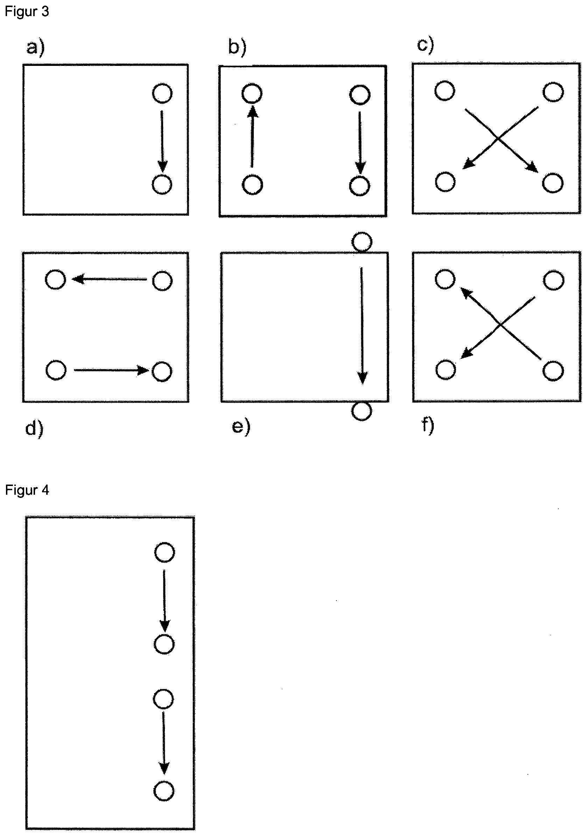

Die Figur 3 zeigt Varianten der Anordnung von Plasmaquelle und Hohlanode welche die erfindungsgemässe Plasmaerzeugungsvorrichtung zeigt. Dabei deutet die Pfeilspitze immer auf eine Hohlanode und das Pfeilende liegt in der Nähe einer Plasmaquelle. Die Verschaltung ist entsprechend Figur 1 zu legen. Figur 3a zeigt eine einfache anflanschung an die Seitenwand einer Vakuumkammer. Die Figuren 3b, 3c,3d und 3f zeigt die Anflanschung von 2 Plasmaquellen und 2 Anoden, wobei die Stomrichtungen unterschiedliche räumliche Orientierungen aufweisen. Figur 3e stellt schematisch die Anflanschung einer Plasmaquelle an der Decke der Vakuumkammer und die Anflanschung einer Hohlanode am Boden der Vakuumkammer dar. Bei Vakuumkammern mit grösserer Beladungshöhe können auch zwei erfindungsgemässe Plasmaerzeugungsvorrichtungen übereinander angeordnet werden. Entsprechendes ist in Figur 4 schematisch dargestellt.

Die in dieser Beschreibung erwähnten Nebenwiderstande 6a und 6b liegen vorteilhafter Weise zwischen einschliesslich 10 Ohm und 100 Ohm, besonders bevorzugt zwischen einschliesslich 20 Ohm und 50 Ohm.

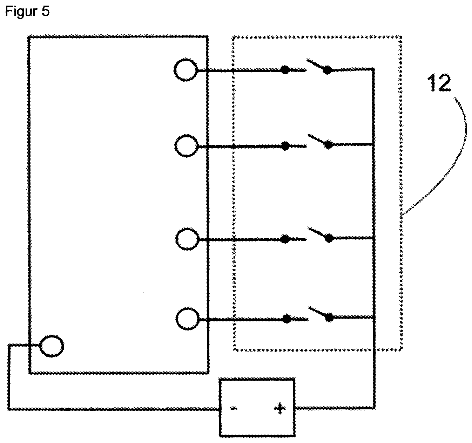

Es kann vorteilhaft sein, nur das Plasma, welches am Anodenkörper erzeugt wird, zu nutzen. Demgemäss werden in einer weiteren, bevorzugten Ausführungsform der vorliegenden eine Vielzahl von Anodenhohlkörpern durch mindestens einen Plasmaquellenhohlkörper durch gleichzeitiges oder sequenzielles oder überlappendes Einschalten der Schalter der Schaltereinheit 12 elektrisch angesteuert. Dies ist in Figur 5 dargestellt wobei die Mittel zum Zünden der Entladung der Einfachheit halber hier nicht dargestellt sind.

Gemäss einer weiteren Ausführungsform der vorliegenden Erfindung kann durch Einsatz von Magnetfeldern die Entladespannung an der Anode erhöht werden. Infolge davon kommt es zu einer Beschleunigung der am Eintrittsloch des Anodenhohlkörpers erzeugten Ionen und damit verbundenen Energiereichen Teilchen. Ebenso können am Plasmaquellenhohlkörper Magnetfelder zum Einsatz kommen.

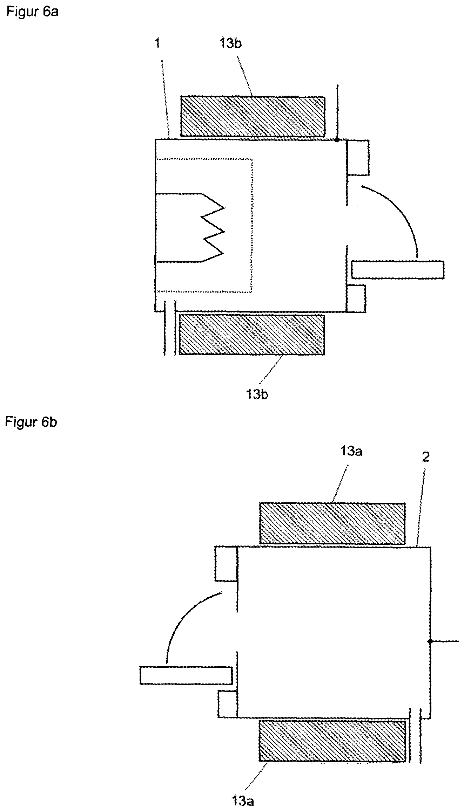

Die Figuren 6a und 6b zeigen einen Plasmahohlköper und einen Anodenhohlkörper mit Mangfelderzeugungseinrichtung 13a und 13b.
Während das Magnetfeld des Plasmahohlkörper 13b eine Führung der Elektronen und damit der Ionen in den Vakuumrezipienten bewirkt, verusacht das Magnetfeld 13a am Anodenhohlkörper eine Ablenkung der Elektronen und damit eine Erhöhung des Sapnnungsabfall vor der Anode (Hall Effekt). Dieses Potential beschleunigt wiederum die ioniserten Gasatome und verleihen diesen eine erhöhte Energie.

### Bezugszeichenliste

- 1: Plasmaquellen Hohlkörper
- 2: Anodenhohlkörper
- 3: Vakuumrezipient
- 4: Isolatoren
- 5: Elektronenemissionseinheit (z.B. Filament und Speisung)
- 6a: Nebenwiderstand Plasmaquelle
- 6b: Nebenwiderstand Anode
- 7a: Gaseinlass Plasmaquelle
- 7b: Gaseinlass Anode
- 8: Spannungsquelle
- 9a: Blende vor Anodenöffnung
- 9p: Blende vor Plasmaquellenöffnung
- 10: Öffnung der Plasmaquelle
- 11: Öffnung der Anode
- 12: Schalteinheit
- 13a: Magnetfeldmittel
- 13b: Magnetfeldmittel

## Patentansprüche

1. Plasmaerzeugungsvorrichtung umfassend
- eine Plasmaquelle mit Plamaquellenhohlkörper (1) und Elektronenemissionseinheit (5) welche es ermöglicht freie Elektronen in den Plasmaquellenhohlkörper (1) zu emittieren wobei der Plasmaquellenhohlkörper (1) einen ersten Gaseinlass (7a) und eine Plasmaquellenöffnung (10) aufweist, welche eine Öffnung zu einer Vakuumkammer bildet
- sowie eine Anode mit Anodenhohlkörper (2), wobei der Anodenhohlkörper (2) einen zweiten Gaseinlass (7b) und eine Anodenöffnung (11) aufweist
- und eine Spannungsquelle (8) deren negativer Pol mit der Elektronenemissionseinheit (5) verbunden ist und deren positiver Pol mit dem Anodenhohlkörper (2) verbunden ist, wobei der positive Pol der Spannungsquelle (8) zusätzlich über einen ersten Nebenwiderstand (6a) mit dem Plasmaquellenhohlkörper (1) elektrisch verbunden ist; **dadurch gekennzeichnet dass** die Anodenöffnung (11) eine Öffnung zu der Vakuumkammer bildet.

2. Plasmaerzeugungsvorrichtung nach Anspruch 1, **dadurch gekennzeichnet, dass** der positive Pol der Spannungsquelle (8) über einen zweiten Nebenwiderstand (6b) mit der Vakuumkammer elektrisch verbunden ist.

3. Plasmaerzeugungsvorrichtung nach einem der Ansprüche 1 oder 2, **dadurch gekennzeichnet, dass** bei der Plasmaquellenöffnung (10) eine Blende (9p) vorgesehen ist mit welcher die Plasmaquellenöffnug (10) bei Bedarf geschlossen werden kann.

4. Plasmaerzeugungsvorrichtung nach einem der Ansprüche 1 bis 3, **dadurch gekennzeichnet, dass** bei bei der Anodenöffnung (11) eine Blende (9a) vorgesehen ist mit welcher die Anodenöffnung (11) bei Bedarf geschlossen werden kann.

5. Plasmaerzeugungsvorrichtung nach einem der vorangehenden Ansprüche, **dadurch gekennzeichnet, dass** die Plasmaquellenöffnung (10) und/oder die Anodenöffnung (11) so ausgebildet sind, dass sich bei Betrieb eine Überschallströmung durch die Öffnung und/oder die Öffnungen aufbauen kann.

6. Verfahren zur Beschichtung von Substraten mittels PE-CVD, wobei Mono- und/oder Polymeres Gas in eine Vakuumkammer, die eine Plasmaerzeugungsvorrichtung umfasst, eingelassen wird und in der Vakuumkammer mittels der Plasmaerzeugungseinrichtung ein Plasma aufgebaut wird und die zu beschichtenden Substrate auf eine negative Spannung gelegt werden, **dadurch gekennzeichnet dass** es sich bei der Plasmaerzeugungsvorrichtung um eine Plasmaerzeugungsvorrichtung nach Anspruch 5 handelt und dadurch weder der Innenraum des Plasmaquellenhohlkörpers (1) noch der Innenraum des Anodenhohlkörpers (2) beschichtet wird.

## Claims

1. A plasma generating apparatus, comprising
- a plasma source having a plasma source hollow body (1) and an electron emission unit (5) which allows the emission of free electrons into the plasma source hollow body (1), wherein the plasma source hollow body (1) comprises a first gas inlet (7a) and a plasma source opening (10) which forms an opening to a vacuum chamber,
- and an anode comprising an anode hollow body (2), wherein the anode hollow body (2) comprises a second gas inlet (7b) and an anode opening (11),
- and a voltage source (8), the negative pole of which is connected to the electron emission unit (5) and the positive pole of which is connected to the anode hollow body (2), wherein the positive pole of the voltage source (8) is additionally electrically connected to the plasma source hollow body (1) via a first shunt (6a),
**characterized in that** the anode opening (11) forms an opening to the vacuum chamber.

2. A plasma generating apparatus according to claim 1, **characterized in that** the positive pole of the voltage source (8) is electrically connected to the vacuum chamber via a second shunt (6b).

3. A plasma generating apparatus according to one of the claims 1 or 2, **characterized in that** a screen (9p) is provided in the plasma source opening (10) with which the plasma source opening (10) can be closed as needed.

4. A plasma generating apparatus according to one of the claims 1 to 3, **characterized in that** a screen (9a) is provided in the anode opening (11), with which the anode opening (11) can be closed as needed.

5. A plasma generating apparatus according to one of the preceding claims, **characterized in that** the plasma source opening (10) and/or the anode opening (11) are formed in such a way that in operation a supersonic flow can be established through the opening and/or the openings.

6. A method for coating substrates by means of PE-CVD, wherein mono gas and/or a polymer gas is admitted to a vacuum chamber which comprises a plasma generating apparatus, and a plasma is established in the vacuum chamber by means of the plasma generating device, and a negative voltage is applied to the substrates to be coated, **characterized in that** the plasma generating apparatus concerns a plasma generating apparatus according to claim 5 and therefore neither the inner space of the plasma source hollow body (1) nor the inner space of the anode hollow body (2) is coated.

## Revendications

1. Dispositif de génération de plasma comprenant :
- une source de plasma avec un corps creux source de plasma (1) et une unité d'émission d'électrons (5) qui permet d'émettre des électrons libres dans le corps creux source de plasma (1), le corps creux source de plasma (1) présentant une première entrée de gaz (7a) et une ouverture de la source de plasma (10), laquelle forme une ouverture menant à une chambre à vide,
- une anode avec un corps creux anode (2), le corps creux anode (2) présentant une deuxième entrée de gaz (7b) et une ouverture d'anode (11),
- et une source de tension (8) dont le pôle négatif est relié à l'unité d'émission d'électrons (5) et dont le pôle positif est relié au corps creux anode (2),
le pôle positif de la source de tension (8) étant relié en plus électriquement au corps creux source de plasma (1) par l'intermédiaire d'une première résistance en dérivation (6a),
**caractérisé en ce que** l'ouverture d'anode (11) forme une ouverture vers la chambre à vide.

2. Dispositif de génération de plasma selon la revendication 1, **caractérisé en ce que** le pôle positif de la source de tension (8) est relié électriquement à la chambre à vide par l'intermédiaire d'une deuxième résistance en dérivation (6b).

3. Dispositif de génération de plasma selon l'une des revendications 1 ou 2, **caractérisé en ce qu'**il est prévu, au niveau de l'ouverture de source de plasma (10) un obturateur (9p) qui permet de fermer l'ouverture de source de plasma (10) si besoin.

4. Dispositif de génération de plasma selon l'une des revendications 1 à 3, **caractérisé en ce qu'**il est prévu au niveau de l'ouverture d'anode (11) un obturateur (9a) qui permet de fermer l'ouverture d'anode (11) si besoin.

5. Dispositif de génération de plasma selon l'une des revendications précédentes, **caractérisé en ce que** l'ouverture de source de plasma (10) et/ou l'ouverture d'anode (11) sont réalisées de telle façon que, pendant le fonctionnement, il est possible d'établir un écoulement supersonique à travers l'ouverture et/ou les ouvertures.

6. Procédé pour recouvrir des substrats à l'aide de PE-CVD, un gaz monomère et/ou polymère étant introduit dans une chambre à vide qui comprend un dispositif de génération de plasma, et un plasma étant généré dans la chambre à vide par l'intermédiaire du dispositif de génération de plasma, et une tension négative étant appliquée aux substrats à revêtir, **caractérisé en ce que** le dispositif de génération de plasma est un dispositif de génération de plasma selon la revendication 5 et **en ce que** ni l'espace intérieur du corps creux source de plasma (1) ni l'espace intérieur du corps creux anode (2) n'est recouvert.
